# EUROPÄISCHE PATENTSCHRIFT

(11) **EP 0 766 377 B1**
(45) Veröffentlichungstag und Bekanntmachung des Hinweises auf die Patenterteilung: **28.11.2001**
(21) Anmeldenummer: 96114920.0
(22) Anmeldetag: 18.09.1996
(51) Int. Cl.: H03F 1/02, H03F 3/21

(54) **Schaltung zur Stromversorgung mehrerer Leistungsverstärker**
Current supply circuit for multiple power amplifiers
Circuit d'alimentation de courant pour plusieurs amplificateurs de puissance

(30) Priorität: 27.09.1995 DE 19535868
(43) Veröffentlichungstag der Anmeldung: 02.04.1997
(73) Patentinhaber: DEUTSCHE THOMSON-BRANDT GMBH, 78048 Villingen-Schwenningen (DE)
(72) Erfinder: Gleim, Günter, 78052 Villingen-Schwenningen (DE); Louvel, Jean-Paul, 78050 Villingen-Schwenningen (DE); Chauvin, Jacques, 78087 Mönchweiler (DE)
(74) Vertreter: Rossmanith, Manfred, Dr.

(56) Entgegenhaltungen:
- EP-A- 0 515 853
- US-A- 3 684 940
- US-A- 4 054 843
- US-A- 4 721 919

## Beschreibung

Die Erfindung geht aus von einer Schaltung zur Stromversorgung mehrerer Leistungsverstärker gemäß dem Oberbegriff des Anspruchs 1. Eine derartige Schaltung dient in einer Projektions-Fernsehanlage dazu, sechs Verstärker zur Ansteuerung der Korrekturspulen für die Konvergenz der Farben Rot, Grün und Blau, jeweils in horizontaler und vertikaler Richtung, mit Betriebsspannung zu versorgen.

Eine derartige Schaltung zur Speisung mehrerer Leistungsverstärker erfordert im allgemeinen einen erheblichen Aufwand, insbesondere, wenn wie bei der Konvergenz ein hoher Frequenzgang erforderlich ist und das Netzteil für den Fall ausgelegt sein muß, daß alle Verstärker gleichzeitig voll ausgesteuert werden. Dadurch, daß die von dem Netzteil erzeugten Betriebsspannungen im allgemeinen stabilisiert sind, treten in dem Netzgerät und den Verstärkern erhebliche Verlustleistungen auf.

Aus der US 4,721,919 ist eine Schaltung zur Stromversorgung zweier Leistungsverstärker bekannt, bei der der Ausgang eines geregelten Netzteils an die Stromversorgungsanschlüsse der Verstärker angeschlossen ist, und die Ausgangsspannung des Netzteils so geregelt ist, daß sie jeweils für den Verstärker, der das Ausgangssignal mit der größten Amplitude aufweist, ausreichend hoch ist. Die beiden Ausgänge der Verstärker sind hierbei in einer Brückenschaltung an einer Lautsprecherspule angeschlossen, die hierdurch im Gegentakt betrieben wird. Die Ausgangssignale der beiden Verstärker werden jeweils über eine Diode einer Regelschaltung zugeführt, die die Ausgangsspannung des Netzteils bei hohen Ausgangssignalen der Verstärker anhebt.

Der Erfindung liegt die Aufgabe zugrunde, bei der eingangs genannten Schaltung den Schaltungsaufwand für das Netzteil sowie die Verlustleistung in dem Netzteil und in den Verstärkern zu verringern. Diese Aufgabe wird durch die im Anspruch 1 angegebene Erfindung gelöst Vorteilhafte Weiterbildungen der Erfindung sind in den Unteransprüchen angegeben.

Die Erfindung beruht auf folgenden Überlegungen und Erkenntnissen. Bei einer Stromversorgungsschaltung für mehrere Verstärker der beschriebenen Art ist die jeweilige Aussteuerung der Verstärker durch die Signale, z.B. für die Konvergenz bei einer Projektions-Fernsehanlage, sehr unterschiedlich und kann bei jedem Verstärker praktisch von null bis zur Maximalaussteuerung schwanken. Es ist daher vorteilhaft, zunächst festzustellen, an welchem der Verstärker das Ausgangssignal jeweils in einem Augenblick die maximale Amplitude hat. In Abhängigkeit von dieser Amplitude wird dann die Ausgangsspannung des Netzteils, die als Betriebsspannung parallel an alle Verstärker gelangt, so geregelt, daß sie für diesen Verstärker gerade ausreichend ist. Die vom Netzteil gelieferte Betriebsspannung wird also in jedem Augenblick der tatsächlichen Amplitude des Ausgangssignals am Ausgang des maximal ausgesteuerten Verstärkers angepaßt. Dann bekommen zwangsläufig auch alle anderen Verstärker eine ausreichende Betriebsspannung, weil an diesen Verstärkern die Amplitude des Signals geringer ist. Durch diese Anpassung der von Netzteil erzeugten Betriebsspannung an die tatsächliche Aussteuerung des Verstärkers mit der maximalen Ausgangsamplitude wird die Verlustleistung sowohl in dem Netzteil als auch in den Verstärkern verringert.

Insbesondere sind die Ausgangssignale aller Verstärker an eine Schaltung angelegt, die nur auf das Ausgangssignal mit der größten Amplitude anspricht. Aus diesem Ausgangssignal wird dann eine Regelspannung abgeleitet und einem Regeleingang des Netzteils zugeführt.

Bei einer praktisch erprobten Schaltung sind die Ausgänge der Verstärker über erste, gleichsinnig gepolte Dioden mit einem ersten gemeinsamen Schaltungspunkt verbunden, der an den Regeleingang des Netzteils angeschlossen ist. Zur Auswertung der positiven und negativen Halbwellen der Ausgangsspannungen der Verstärker sind dabei die Ausgänge der Verstärker zusätzlich über zweite, gegensinnig zu den ersten Dioden gepolte Dioden mit einem zweiten Schaltungspunkt verbunden, der über einen Inverter an den ersten Schaltungspunkt angeschlossen ist.

Vorzugsweise liefert das Netzteil eine positive Betriebsspannung und eine gleich große negative Betriebsspannung für die einzelnen im Gegentakt arbeitenden Verstärker. Diese Betriebsspannungen sind vorzugsweise gleich groß und werden in Abhängigkeit von der Amplitude des Signals stets auf gleiche Werte geregelt.

Gemäß einer Weiterbildung der Erfindung werden die beiden Betriebsspannungen mit entgegengesetzter Polarität in zwei getrennten Netzteilen erzeugt und unabhängig voneinander geregelt, haben also nicht mehr gleiche Amplitude. Vorzugsweise wird die positive Betriebsspannung in Abhängigkeit von den positiven Halbwellen des Signals und die negative Betriebsspannung in Abhängigkeit von den negativen Halbwellen des Signals geregelt.

Die Erfindung wird im folgenden anhand der Zeichnung erläutert. Darin zeigen
- Fig. 1: ein Ausführungsbeispiel der erfindungsgemäßen Schaltung und
- Fig. 2: im Prinzip die Abhängigkeit der von dem Netzteil erzeugten Betriebsspannungen von der jeweiligen Amplitude des Signals am Ausgang eines Verstärkers.

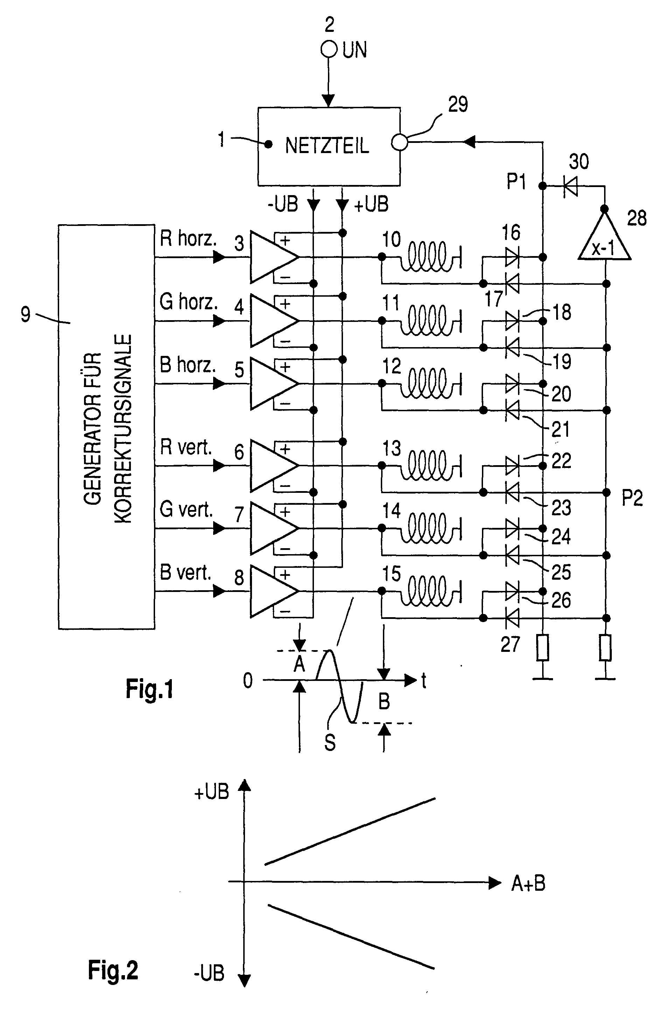

In Fig. 1 ist das Netzteil 1 an eine die Netzspannung UN führende Klemme angeschlossen. Das Netzteil 1 erzeugt zwei gleich große Betriebsspannungen +UB und -UB entgegengesetzter Polarität. Diese Betriebsspannungen +UB und -UB sind parallel an die Betriebsspannungseingänge von sechs Verstärkern 3 - 8 angelegt, deren Ausgänge an Korrekturspulen 10 - 15 angeschlossen sind. Die Korrekturspulen 10 - 15 dienen zur Korrektur der Konvergenz für die Farben Rot, Grün und Blau, sowohl in horizontaler als auch in vertikaler Richtung in einer Projektions-Fernsehanlage. Dazu werden die Verstärker 3 - 8 von dem Generator 9 mit entsprechenden Korrektursignalen gespeist. Die soweit beschriebene Schaltung ist bekannt.

Die Ausgänge der Verstärker 3 - 8 sind über Dioden 16, 18, 20, 22, 24, 26 mit dem Schaltungspunkt P1 verbunden, der an den Regeleingang 29 des Netzteils 1 angeschlossen ist. Die Ausgänge der Verstärker 3 - 8 sind außerdem über entgegengesetzt gepolte Dioden 17,19, 21, 23, 25, 27 mit dem Schaltungspunkt P2 verbunden, der über den Inverter 28 und die Diode 30 an den Schaltungspunkt P1 angeschlossen ist.

Die Wirkungsweise wird anhand der Fig. 2 erläutert. Es wird angenommen, daß das Signal S des Verstärkers 8 die maximale Amplitude hat, also die Ausgangsspannungen der Verstärker 3 - 7 eine geringere Amplitude aufweisen. Durch die positive Halbwelle mit der Amplitude A wird die Diode 26 leitend gesteuert, so daß diese Halbwelle an den Schaltungspunkt P1 gelangt. Dadurch sind zwangsläufig die Dioden 16, 18, 20, 22, 24 gesperrt, weil die Amplituden der Ausgangsspannungen der Verstärker 3 - 7 geringer sind. Durch die negative Halbwelle mit der Amplitude B ist die Diode 27 leitend und entsprechend die Dioden 17, 19, 21, 23, 25 gesperrt. Die Halbwelle mit der Amplitude B wird in dem Inverter 28 umgepolt und mit gleicher Polarität der Halbwelle mit der Amplitude A am Schaltungspunkt P1 addiert. Das Eingangssignal an dem Regeleingang 29 ist also ein Maß für die Amplitude des Ausgangssignals des Verstärkers 8. In Abhängigkeit von dieser Amplitude werden nun die Betriebsspannungen +UB und -UB auf einen solchen Wert geregelt, der für die Amplitude des Signals S am Verstärker 8 gerade ausreichend ist. Dadurch sind auch die Betriebsspannungen +UB und -UB für die Verstärker 3 - 7 ausreichend groß, da an diesen Verstärkern das Signal eine geringere Amplitude hat als am Verstärker 8.

Gemäß Fig. 2 ist die Amplitude der Betriebsspannungen +UB und -UB stetig analog von der Amplitude A+B abhängig. Die Amplitude der Betriebsspannungen +UB und -UB kann auch stufenweise von der Amplitude des Signals S abhängig sein. Beispielsweise können mehrere verschiedene Betriebsspannungen unterschiedlicher Amplitude je nach Amplitude des Signals S an die Verstärker 3 - 8 angeschaltet werden.

Bisher wurde angenommen, daß die beiden Betriebsspannung +UB und -UB gemäß Fig. 2 bei allen Werten des Signals A+B gleiche Amplitude haben. Es ist auch möglich, die beiden Betriebsspannungen +UB und -UB in getrennten Netzteilen zu erzeugen und die Höhe der Betriebsspannung +UB in Abhängigkeit von der positiven Amplitude A des Signals S und die negative Betriebsspannung -UB in Abhängigkeit von der Amplitude B der negativen Halbwelle des Signals S zu regeln. Dadurch kann eine noch bessere Anpassung der Betriebsspannung an die wirklichen Amplituden des Signals und eine weitere Leistungseinsparung erreicht werden.

## Patentansprüche

1. Schaltung zur Stromversorgung mehrerer Leistungsverstärker (3 - 8) zur Korrektur der Konvergenz in einer Projektions-Fernsehanlage, mit einem gemeinsamen, geregelten Netzteil (1), dessen Ausgang an die Stromversorgungsanschlüsse der Verstärker (3- 8) angeschlossen ist, und die Ausgänge der Verstärker (3 - 8) jeweils an einem Ende einer der Korrekturspulen (10 - 15) für die horizontale und vertikale Konvergenz für Rot, Grün und Blau angeschlossen sind, wobei die Korrekturspulen (10 - 15) mit ihrem anderen Ende an Masse liegen, **dadurch gekennzeichnet,**
**daß** die Ausgangsspannung (+UB, -UB) des Netzteils (1) so geregelt ist, daß sie in jedem Augenblick für den Verstärker (8) ausreichend hoch ist, der in diesem Augenblick das Ausgangssignal (S) mit der größten Amplitude (A + B) aufweist, indem zur Generierung einer Regelspannung die Ausgänge der Verstärker (3 - 8) jeweils über erste, gleichsinnig gepolte Dioden (16, 18, 20, 22, 24, 26) mit einem ersten gemeinsamen Schaltungspunkt (P1) verbunden sind, der an einen Regeleingang (29) des Netzteils (1) angeschlossen ist, und die Ausgänge der Verstärker (3 - 8) jeweils über zweite, gegensinnig zu den ersten Dioden gepolte Dioden (17, 19, 21, 23, 25, 27) mit einem zweiten Schaltungspunkt (P2) verbunden sind, der über einen Inverter (28) an dem ersten Schaltungspunkt (P1) angeschlossen ist.

2. Schaltung nach Anspruch 1, **dadurch gekennzeichnet, daß** das Netzteil (1) jeweils für einen Verstärker eine positive Betriebsspannung (+UB) und eine negative Betriebsspannung (-UB) liefert.

3. Schaltung nach Anspruch 2, **dadurch gekennzeichnet, daß** die positive Betriebsspannung (+UB) und die negative Betriebsspannung (-UB) unabhängig voneinander in der Amplitude geregelt sind.

4. Schaltung nach Anspruch 3, **dadurch gekennzeichnet, daß** die positive Betriebsspannung (+UB) in Abhängigkeit von der Amplitude (A) der positiven Halbwelle des Ausgangssignals (S) und die negative Betriebsspannung (-UB) in Abhängigkeit von der Amplitude (B) der negativen Halbwelle des Ausgangssignals (S) geregelt ist.

## Claims

1. Circuit for the power supply of a plurality of power amplifiers (3 - 8), for correction of convergence within a projection television equipment including a common regulated power supply unit (1) having its output connected to the power supply terminals of the amplifiers (3 - 8), wherein the output terminals of the amplifiers (3-8) are each connected to one end of one of the correction coils (10-15) for horizontal and vertical convergence for Red, Green and Blue and the other ends of the correction coils (10-15) are connected to ground,
**characterized in that**
the output voltage (+UB, -UB) of the power supply unit (1) is regulated in such a way that at any instant it is high enough for the amplifier (8) which at this instant has the output signal (S) having the largest amplitude (A + B) wherein for generating a control voltage the output terminals of the amplifiers (3 - 8) are connected to a first common circuit point (P1) via first diodes (16, 18, 20, 22, 24, 26) connected in the same polarity, which first common circuit point is connected to a regulating input (29) of the power supply unit (1) and that the output terminals of the amplifiers (3 - 8) are connected to a second circuit point (P2) via second diodes (17, 19, 21, 23, 25, 27) connected in the opposite polarity to the first diodes, which second circuit point is connected to the first circuit point (P1) via an inverter (28).

2. Circuit according to claim 1, **characterized in that** the power supply unit (1) in each case supplies for an amplifier a positive operating voltage (+UB) and a negative operating voltage (-UB).

3. Circuit according to claim 2, **characterized in that** the positive operating voltage (+UB) and the negative operating voltage (-UB) are regulated independently of one another in terms of amplitude.

4. Circuit according to claim 3, **characterized in that** the positive operating voltage (+UB) is regulated as a function of the amplitude (A) of the positive half-cycle of the output signal (S) and the negative operating voltage (-UB) is regulated as a function of the amplitude (B) of the negative half-cycle of the output signal (S).

## Revendications

1. Circuit d'alimentation de courant pour plusieurs amplificateurs de puissance (3 à 8) pour la correction de la convergence dans un téléviseur de projection équipé d'un bloc d'alimentation (1) commun réglé dont la sortie est reliée à la connexion d'alimentation de courant des amplificateurs (3 à 8) et dans lequel chaque sortie des amplificateurs (3 à 8) est connectée à une extrémité d'une bobine de correction (10 à 15) pour la convergence horizontale et verticale des couleurs rouge, verte et bleue, où l'autre extrémité de ces bobines est mise à la terre, **caractérisé en ce que** la tension de sortie (+UB, -UB) du bloc d'alimentation (1) est réglée de façon à être à tout moment suffisamment élevée pour l'amplificateur (8) qui présente le signal de sortie (S) possédant la plus grande amplitude (A + B), dans lequel, pour générer une tension de réglage, les sorties des amplificateurs (3 à 8) sont reliées via des premières diodes polarisées de même sens (16, 18, 20, 22, 24, 26) à un premier point de commutation commun (P1) connecté à une entrée de réglage (29) du bloc d'alimentation (1) et, via d'autres diodes polarisées (17, 19, 21, 23, 25, 27) en sens inverse par rapport aux premières, à un deuxième point de commutation (P2) connecté au premier point de commutation (P1) par un inverseur (28).

2. Circuit conforme à la revendication 1, **caractérisé en ce que** le bloc d'alimentation (1) fournit une tension de service positive (+UB) et une tension de service négative (-UB) pour chaque amplificateur.

3. Circuit conforme à la revendication 2, **caractérisé en ce que** l'amplitude des tensions de service positive (+UB) et négative (-UB) est réglée de façon indépendante.

4. Circuit conforme à la revendication 3, **caractérisé en ce que** la tension de service positive (+UB) est réglée en fonction de l'amplitude (A) de la demi-onde positive du signal de sortie (S) et la tension de service négative (-UB) en fonction de l'amplitude (B) de la demi-onde négative du signal de sortie (S).
